# EUROPEAN PATENT APPLICATION

(11) **EP 4 617 399 A2**
(43) Date of publication of application: **17.09.2025**
(21) Application number: 25159011.3
(22) Date of filing: 20.02.2025
(51) Int. Cl.: C23C 16/04, A61J 1/14, B65D 23/02, C03C 17/00, C23C 16/40, C23C 16/455

(54) **PROTECTIVE COATING FILMS AND METHODS FOR MANUFACTURING THEREOF**

(30) Priority: 04.03.2024 FI 20245264
(71) Applicant: Picosun Oy, 02150 Espoo (FI)
(72) Inventor: MANNINEN, Ilkka, 02150 Espoo (FI); HIRSJÄRVI, Samuli, 02150 Espoo (FI); RITASALO, Riina, 02150 Espoo (FI); TASKINEN, Juhani, 02150 Espoo (FI)
(74) Representative: Heinonen & Co

(57) **Abstract**

The disclosure concerns a coating film, a method of manufacturing the same, and coated items, respectively. The film is deposited by a process of Atomic Layer Deposition (ALD) on a substrate configured as a receptacle- and/or packaging item for chemical formulations, such as pharmaceuticals. The coating film is deposited on a substrate surface that comes into direct contact with a chemical formulation stored therein, and provides a barrier that prevents leachable substances from migrating out of the substrate material and hence contaminating the contents of the receptacle and/or packaging item. The coating film is heat-resistant and withstands sterilization.

## Description

### FIELD OF THE INVENTION

The present invention generally relates to production of thin films with a barrier function by chemical deposition methods. In particular, the invention concerns manufacturing, preferably by Atomic Layer Deposition, of coatings on primary packaging items to provide a barrier against impurities migrating out of a packaging material into the contents of the package.

### BACKGROUND OF THE INVENTION

Product-container interactions are crucial consideration when selecting primary packaging components for stored substances, in particular, pharmaceutical preparations. Primary packaging refers to a packaging material or a layer that comes into direct contact with a product stored in the package thus serving as an immediate contact surface between the stored product and its environment. Any unwanted interactions between the product and the packaging material can significantly impact the stability, purity, efficacy, concentration, and safety of the product.

Formation of extractables and leachables from primary packaging materials, such as glass and/or polymeric packaging components (the latter including elastomeric caps and stoppers, flexible bags, etc.) is a well-known challenge in drug storage.

Leachables are substances, that migrate out of the primary packaging under normal storage or use conditions. Extractables are, in turn, substances that migrate out of the packaging material under so-called laboratory conditions, i.e. conditions that are typically not experienced by a product upon its normal storage or use, such as for example, higher or lower temperatures, prolonged storage, or exposure to solvents or other aggressive environments. Any one of extractables and leachables, when released into the contents of the package, introduce impurities, contaminants, or reactive compounds into the product stored in the package. Some formulations are more susceptible for harmful interactions with substances leaching from the container wall than the others. Such interaction often results in formation of degradation products, which, in turn, affects product quality over time and, if the product is a drug, may introduce effects that potentially impact safety of a patient. By way of example, delamination, that potentially leads to formation of microparticulate that could leach into the product, has been observed in different glass containers, including type I (borosilicate) glass which is one of the most common packaging material in pharmaceutical industry.

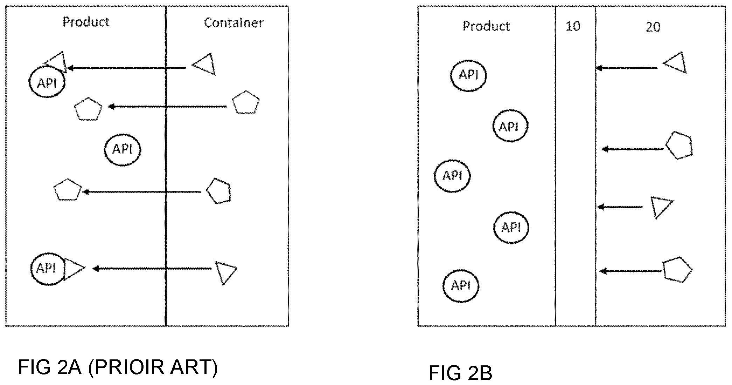

Product-container interaction is schematically illustrated on Fig. 2A. Substances (e.g. extractable and leachables) released into the product from the container material are shown with triangles and pentagons. When released into the drug product, these substances may be present in the drug product formulation as impurities, or they may react with an active pharmaceutical ingredient ("API") or with each other. Altogether, these interactions, result in contamination of the product and/or loss of its functionality.

A problem of formation of extractable and leachable substances has been addressed so far through a number of technologies generally aiming at modifying/optimizing packaging materials and/or applying barrier coatings or linings. For example, U.S. patent no. US 6,537,626 B1 (Spallek et al.) discusses that a 150 nm SiO₂ coating layer applied on an inner surface of a borosilicate glass container by plasma impulse Chemical Vapour Deposition (PICVD) decreases a leachable quantity of various cations (Na, Ca, B, Al and Si) from about 3.5-5 µg/L to less than 0.01 µg/L (Na, B), less than 0.03 µg/L (Si), and less than 0.05 µg/L (Ca, Al).

However, CVD films typically suffer from thickness non-uniformity, especially in complex geometries or on non-planar surfaces. CVD reactions are typically harder to control and optimize, hence, making it difficult to achieve precise control over film thickness, composition, and/or properties. Especially in medical packaging applications that have to comply with strict quality standards, insufficient film thickness uniformity may be a limiting factor.

Atomic Layer Deposition (ALD) is a technique of deposition of thin films in vapour phase which is extensively described in the art. ALD technology has proved an efficient tool for manufacturing ultra-thin, high-quality conformal coatings on a variety of three-dimensional substrate structures.

ALD is based on alternating self-saturative surface reactions, wherein different reactants (precursors) provided as molecular compounds or elements in a nonreactive (inert) gaseous carrier are sequentially pulsed into a reaction space accommodating a substrate. ALD films typically include metal oxides, elemental metals, metal nitrides, metal sulfides, where metal halides, metal alkylamides and water, for example, are used as ALD precursors to deposit these films. These films, may be deposited on a nano-scale on complex shaped substrates with excellent large area uniformity and extremely high precision control.

In this regard, prospects of application of ALD techniques in the field of manufacturing items for enclosing and/or storing products, susceptible to product-container interactions, should further be investigated.

### SUMMARY OF THE INVENTION

An objective of the present invention is to solve or to at least alleviate each of the problems arising from the limitations and disadvantages of the related art. The objective is achieved by various embodiments of a coating film, a method of manufacturing the same, and coated items. In an aspect, a coating film is provided according to what is defined in independent claim 1.

In an embodiment, the coating film is deposited by a process of Atomic Layer Deposition (ALD) on at least one surface of a substrate configured to contain a product susceptible to interaction with a substrate material upon being brought into direct contact therewith, the coating film providing a barrier to substances migrating out of the substrate material into its contents, i.e. into the product contained in the substrate, thereby preventing said substances from contaminating the product contained in the substrate.

In embodiments, the coating film comprises one or more layers composed of any one of: aluminium(III) oxide (Al₂O₃), titanium(IV) oxide (TiO₂), hafnium(IV) oxide (HfO₂), zirconium(IV) oxide (ZrO₂), zinc oxide (ZnO), tantalum(V) oxide (Ta₂O₅), silicon dioxide (SiO₂), and combinations thereof.

In an embodiment, the coating film is configured as a laminate structure, in which the layers are arranged into repetitive patterns, wherein each said pattern comprises two (2) to four (4) layers composed of non-identical chemical compounds.

In an embodiment, the coating film is configured as a barrier against extractables and/or leachables releasing from the substrate material upon interaction between the product and the substrate material (such as container material).

The thickness of the coating film can vary within a range of about 1 nm to about 300 nm, typically, within a range of about 5 nm to about 300 nm, in some instances, within a range of about 20 nm to about 150 nm.

In an embodiment, composition and/or thickness of said coating film is/are determined based on a material of the substrate to be coated and/or based on a composition of the product be contained in the substrate.

In an embodiments, the coating film is deposited on the substrate configured as glass and/or polymer, preferably, elastomer.

In an aspect, a method of depositing a coating film on a receptacle- and/or packaging item is provided, according to what is defined in the independent claim 7. The method pertains to manufacturing of a coated receptacle- and/or packaging item.

In an embodiment, said receptacle- and/or packaging item or parts thereof is/are made of glass and/or polymer, preferably, elastomer.

In an embodiment, said receptacle- and/or packaging item is configured as a primary package for products. The products may include any one of chemical formulations, biological formulations (e.g. proteins), or pharmaceutical preparations.

In an embodiment, composition and/or thickness of the coating film deposited by the method is/are determined based on a material of the receptacle- and/or packaging item to be coated and/or based on a composition of the product to be contained in said receptacle- and/or packaging item.

In a further aspect, a receptacle- and/or packaging item is provided, according to what is defined in independent claim 13. Said receptacle and packaging item comprises, on at least one surface thereof, a coating film according to some previous aspect and embodiments and/or deposited with a method according to some previous aspect and embodiments. The coating film is preferably provided on those surface(s) of said item which are configured to come into direct contact with the product contained therein.

In embodiments, the receptacle- and/or packaging item is configured to contain a product provided in a liquid form, a gel-like form or a solid form, including preparations pressed into shape, particulates and powders. In embodiments, the receptacle- and/or packaging item is configured as a vial, a bottle, a flask, an ampule, a bag, a sample tube, a syringe, a cartridge, an injector pen, and the like.

In still further aspect, a container system for storing a products provided, according to what is defined in the independent claim 17. The container system comprises a container body and a closure element for said container body, wherein a surface or surfaces of any one of the container body and the closure element, or both, configured to come into direct contact with the contents of the container system is/are coated with a coating film according to some previous aspect and embodiments and/or deposited with a method according to some previous aspect and embodiments.

In an embodiment, the container body of said container system is made of glass and the closure element is made of polymer, preferably elastomer. In an embodiment, the container body of said container system is configured as a vial and the closure element is configured as a stopper or a seal.

In still further aspect, use of the receptacle and/or packaging item according to some previous aspect and embodiments and/or of the container system according to some previous aspect and embodiments for storing products is provided, as defined in the independent claim 20. Stored products can be represented with chemical formulations, biological formulations, or pharmaceutical preparations.

The utility of the present invention arises from a variety of reasons depending on each particular embodiment thereof.

Overall, the present invention offers a variety of coating films that prevent potentially harmful substances contained in packaging materials from contacting the contents of the package. By preventing extractables and leachables from reaching the product, the barrier coatings presented herewith eliminate or at least significantly reduce risks associated with potential contamination of products, such as drugs, with substances originating from packaging materials, thus ensuring product safety, stability, and regulatory compliance throughout the supply chain.

ALD films can change surface free energy (hydrophilicity/hydrophobicity) and surface electric charge of the materials to be coated. This further contributes to improved properties provided by ALD coatings.

The invention offers a versatile solution for manufacturing coating films on various types of containers, which versatility is underlined by determining composition and/or thickness of said coating films based on the material properties of the container and/or on the nature of the product(s) to be stored in the container.

The coating films presented herewith are durable, stable and inert, and hence, they maintain their effectiveness over time, even with prolonged contact with the contained product. Therefore, they can be used, in additional to glass containers traditionally used in pharmaceuticals packaging, also on emerging packaging solutions intended for longer-term liquid formulation storage, such as prefilled syringes, cartridges or autoinjectors.

Deposition layers deposited by ALD methods are pinhole-free and fully conformal, therefore, the ALD technology has a high potential in manufacturing of high-quality coatings required for various applications, in particular, medical applications. Due to relatively low temperatures utilized during ALD depositions (about 50 °C and above), the coatings can be conformally deposited also on sensitive substrate materials. Hence, the coatings disclosed herewith are applicable to a large range of substrates including, but not limited to packaging items (e.g. containers, vials, syringes, etc.) made of glass and/or plastic; medical preparations, lab-on-a-chip and other microfluidic devices; closures and other parts for the above-mentioned devices. The (nano)laminate coating is particularly suitable for use in medical segment, such as for biopharmaceuticals packaging, to serve as a protective, non-toxic and long-lasting medical coating solution.

ALD provides a superior capability to coat any kind of complex three-dimensional structures, including porous structures, through its inherent conformality. Hence, the technology allows for applying barrier encapsulation also on medical preparations, e.g. capsules, pills, or tablets.

Additionally, ALD coatings are typically provided in a nanometer scale, hence, they cause minimal dimensional change to the substrate.

The barrier coating films disclosed herewith are transparent and hence enable unhindered see-through visibility with a human eye. This facilitates visual inspection of a drug provided in a glass or plastic vial for example, and allows for immediate detection of precipitate and/or impurities in the vial, thus enhancing the patient's safety. The term "patient" is used herein to describe any human or non-human animal subject, and the like.

In the present disclosure, materials with a layer thickness below 1 micrometer (µm) are referred to as "thin films".

The terms "substrate" or "item" are used in the present disclosure to indicate a physical object which is intended to undergo coating by the methods disclosed herewith. The substrate may thus be any suitable item before coating.

The terms "stack" or "laminate structure" are used in the present disclosure to indicate a layered structure, which comprises two or more layers arranged on top of one another. The stack comprises layers deposited with chemical deposition methods, including ALD, it's analogues and modifications (such as for example plasma enhanced- or photon enhanced ALD), and in some instances, MLD, unless explicitly indicated otherwise.

The terms "coating", "coating film" and "film" are intended, within the present disclosure, to have the same meaning, namely, to define a layer or layers of a substance that covers a surface of a substrate. Unless explicitly stated otherwise, these terms are used, in the present disclosure, to refer to a final coating deposited on the substrate and imparted with all desired/required functionalities. Substrate or item having "coating" or "coating film" or "film" deposited thereon is referred to as a "coated substrate" or a "coated item", respectively.

The term "container" is intended, in the context of the present disclosure, to cover any vessel or object configured to contain, hold, store and transport a substance, preferably, a non-gaseous substance, and suitable for being coated with the barrier coating film, according to the embodiments.

The term "product" is intended, in the context of the present disclosure, to cover any composition or matter that can be contained, held, stored, and transported in the "container", according to the definition above. The term is intended to cover pharmaceutical products, such as drugs and medicinal preparations, for humans and animals, preparations for cosmetic treatments, homeopathic preparations, chemical compounds and compositions used in detection, testing and analytics in medicine, chemistry, biology, biochemistry, food industry, and in related industries and the branches of science.

The term "pharmaceutical preparation" is used in the present disclosure to indicate any compound/substance or a combination of compounds/substances for treating or preventing diseases in humans or animals. The term hence covers preparations to be used in therapy, medical detection, testing and analytics, cosmetic treatments, as well as veterinary preparations.

The expressions "reactive fluid" and "precursor fluids" are indicative in the present disclosure of a fluidic flow comprising at least one chemical compound (a precursor compound), hereafter, a precursor, in an inert carrier. In some instances, precursor fluid contains a precursor compound co-dosed with another precursor compound in inert gas carrier. The expression "set of precursors" relates to two or more precursor compounds used to deposit an individual material (deposition) layer.

The expression "a number of' refers herein to any positive integer starting from one (1), e.g. to one, two, or three; whereas the expression "a plurality of" refers herein to any positive integer starting from two (2), e.g. to two, three, or four.

The terms "first" and "second" are not intended to denote any order, quantity, or importance, but rather are used to merely distinguish one element from another, unless explicitly stated otherwise.

### BRIEF DESCRIPTION OF THE DRAWINGS

Figs. 1A-1C schematically illustrate a coating film 10, according to the embodiments, on a substrate 20.
Fig. 2A is a schematic illustration of a product-container interaction in conventional (uncoated) packaging systems. Fig. 2A is a schematic illustration of a barrier function of the coating film 10 relative to substances released from the substrate 20.
Fig. 3 is a graph showing the results of water conductivity shift measurement tests conducted for the coating film 10.
Fig. 4 (A-F) shows the results of Inductively Coupled Plasma Optical Emission Spectroscopy (ICP-OES) studies conducted for selected coating films 10.
Fig. 5 shows scanning electron microscopy (SEM) images obtained for a borosilicate glass vial surface, wherein image A shows a surface of uncoated vial prior to accelerated soaking test; image B shows a surface of uncoated vial after the accelerated soaking test; and image C shows a surface of a vial coated with 100 nm ZrO₂ coating film 10 after the accelerated soaking test.
Fig. 6 shows an exemplary receptacle- and/or packaging item 100 coated with the coating film 10 (image B) according to the embodiments compared to conventional (uncoated) items (images A and C).
Fig. 7 schematically illustrates an exemplary container system 110, comprising the coating film 10, according to the embodiment.

### DETAILED DESCRIPTION OF THE EMBODIMENTS

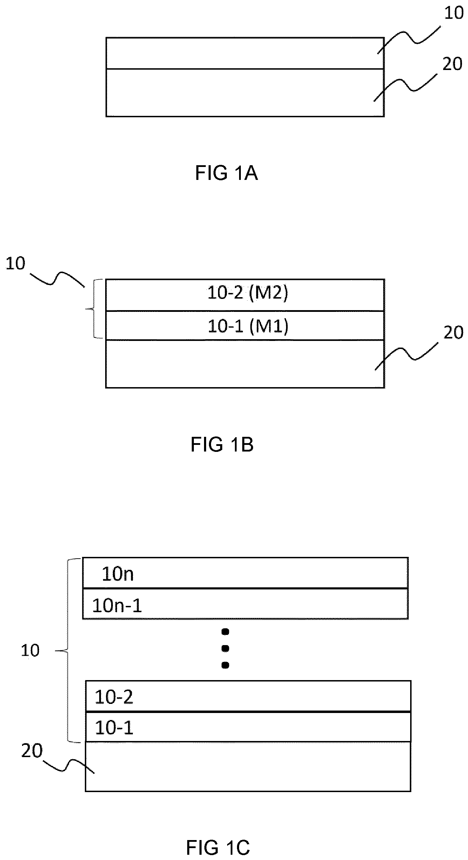

Figs. 1A, 1B and 1C illustrate a coating film 10 implemented according to the embodiments and rendered with a barrier functionality relative to substances migrating out of a primary packaging material upon product-container interaction, and hence preventing contamination of products with these substances.

The coating film 10 is designed to be deposited on a substrate 20. The substrate 20 is advantageously configured to contain and/or store contents susceptible to interaction with a substrate material when being brought into direct contact therewith. The contents of the (coated) substrate 20 is represented, in the context of the present disclosure, with a product configured as any compound or a mixture of compounds susceptible to contamination and/or modification, including degradation and/or loss of its activity/function, upon its interaction with the substrate material.

Substrates 20 made of glass and/or polymer materials can be utilized. Different glass substrates can be utilized, such as borosilicate glass (Type I glass), soda-lime-silica glass (Type II glass), soda-lime glass (Type III glass), etc. Exemplary polymers include, but are not limited to: Cyclic Olefin Polymers (COPs), Cyclic Olefin Copolymers (COCs), polypropylene (PP), and organic/inorganic hybrid polymer polydimethylsiloxane (PDMS). Amongst those, borosilicate glass is the standard glass for primary packaging of pharmaceutical compounds, while COP and COC represent novel, but rapidly emerging types of plastic materials for primary packaging. In some embodiments, the polymer is preferably an elastomer. Exemplary elastomers include, but are not limited to: silicone rubber (VMQ), fluoroelastomers (FKM), styrene-butadiene rubber (SBR), ethylene propylene diene monomer (EPDM), butyl rubber (IIR), polyisoprene rubber, and the like. In embodiments, the elastomer is a medical grade elastomer.

The coating film 10 is preferably configured as a barrier against substances commonly referred to as extractables and leachables, including their degradants and reaction products, that release out of the substrate material upon interaction between the substrate 20 and its contents. Leachables are compounds or elements that migrate out of packaging components into product formulations under normal conditions of storage or use, whereas extractables are compounds or elements that can be extracted out of the packaging components under conditions not considered as "normal", i.e. under prolonged storage or at higher/lower temperature ranges, for example. Although extractables testing is often designed to be chemically aggressive, not every possible substance that leaches out of a material under normal conditions can be extracted in extraction tests. This is of particular importance for drug products with extended shelf-life; and hence, an issue to consider when designing barrier coatings.

Major extractables from glass include alkali, such as sodium oxide (Na₂O), and silica (SiO₂), along with some minor extractables, such as kalium (K₂O), boron (B₂O₃), calcium, (CaO), aluminium (Al₂O₃), and trace amounts of iron and arsenic (some glasses can contain arsenic oxide (III) as a transparency-improving agent). Amongst those, alkali release causes pH shift in unbuffered solutions, while release of metals can trigger chemical reactions leading to precipitation of some salts contained in pharmaceutical products. On the other hand, silicon oil residues originating from siliconized glass surfaces and becoming leachables may lead to denaturation of proteins (e.g. in protein drug formulations) and/or cause them to aggregate. or form aggregates.

In case of polymer compounds, such as COPs, COCs and PPs, degradation products include organic compounds (organic acids, aldehydes, ketones, and alcohols), various additives, such as for example pigments, and other residues (e.g. monomers and/or processing residues).

In this regards, composition and/or thickness of the coating film 10 is preferably adjusted substrate- and/or product-wise to preserve its barrier function on a variety of substrates. Hence in some instances it is preferred that the coating film 10 is configured unreactive towards the contents of the substrate and towards the substances released from the substrate. Whether the coating film 10 is configured as a multilayer laminate stack, composition of layers interfacing the substrate and the product are of particular importance. For example, an outermost layer of the coating film 10 interacts with the product and, when the product is a pharmaceutical preparation, the outermost layer of the coating film thus interacts with both active pharmaceutical ingredient and the excipient; hence, composition of said outermost layer within the coating film 10 should be properly considered with regard to products intended for storage in the coated container.

In some instances, at least the outermost layer of the coating film 10 is rendered more hydrophobic or more hydrophilic dependent on the nature of the product to be stored in the coated container, in order to avoid adhesion of molecules, such as macromolecules of protein drugs, for example, to the container inner surface. Surface properties can be adjusted by modifying chemical composition of the coating films 10. Typically, metal oxide ALD films create hydrophilic surfaces (with water contact angle, WCA, values below 90°). This was confirmed by measuring WCAs of the coating films 10 deposited as described above after exposure to ambient conditions for 1-2 week. For coating films 10 composed of SiO₂, ZrO₂, HfO₂ and TiO₂, the WCA values were 36°, 53°, 57° and 48°, respectively. These WCA values also stand for laminate films comprising the above mentioned oxides as an outermost layer.

On the other hand, ALD-coatings can be rendered hydrophobic by incorporating carbon atoms into the coating structure. This may be achieved by introducing carbon-containing precursors, such as organosilanes (e.g., trimethylsilane), organosilicon compounds (e.g., trimethylaluminum), or other organic molecules, into the ALD process. Alternatively, hydrophobic ALD-surfaces could be created with rare earth oxide coatings, such as for example yttrium oxide or gadolinium oxide. Hydrophobic surfaces are useful in reducing fogging during freeze-drying. Hydrophobic surfaces typically have WCA values above 90°.

In comparison to relatively constant WCA values, surface zeta potential can vary depending on the coating composition. Zeta potential is a measure of electrostatic potential at the interface between the coating and the surrounding fluid and it characterizes the electrical charge of a surface in aqueous (or other solvent) environments. For example, SiO₂ ALD-deposited on various substrates, including borosilicate glass, possesses negative zeta potential values across a wide pH range, being as high as -50 mV at neutral pH (pH 7). On the other hand, zeta potential of ALD-deposited ZrO₂ is negative (-10 mV) at neutral pH (pH 7) and positive below pH 6; whereas zeta potential of ALD-deposited TiO₂ is positive below pH 8, and negative above that [1].

Biological drugs, such as for example protein-based drugs, are amphoteric (contain both positively and negatively charged groups); therefore, their interaction with the primary packaging material is an interplay of various factors such as charge distribution along the molecule chain, molecule orientation at the interface, ionic charge of the solution, pH, as well as surface charge of the container. ALD films can change surface free energy (hydrophilicity/hydrophobicity) and surface electric charge of the material in question. This contributes to improved properties of ALD-coatings and renders the ALD method particularly suitable for altering hydrophilicity/hydrophobicity and charge of primary packaging materials.

In embodiments, composition and/or thickness of the coating film 10 and/or deposition layer thereof is/are preferably determined based on a material of the substrate to be coated and/or based on the product composition. In some instances, the outermost layer or layers of the coating film 10 may be adjusted based on the product composition, while its base layer (interfacing the substrate) is preferably adjusted taking into account the substrate's composition and properties. In many instances it is however preferred that the base layer consists of a material that improves adhesion of the coating film to the substrate.

The product contained in the (coated) substrate 20 includes pharmaceutical preparations, bioactive substances, various biological and/or chemical substances, such as for example proteins, and chemical formulations, including those used in medicine and cosmetic industries, and the like. Some coatings 10 disclosed herewith are particularly designed for packaging systems configured to contain and/or store pharmaceutical preparations.

The product contained in the (coated) substrate is preferably provided in a non-gaseous form, i.e. in essentially liquid, gel-like, or solid forms, wherein liquids include solutions or suspensions of any appropriate consistency, and solids include any one of powders or pressed preparations (e.g. pressed pills).

In an embodiment, the substrate 20 is configured as a receptacle- and/or packaging item configured to contain, store and transport the product described herein above. The packaging item may be configured for any one of short-term or long-term storage. Exemplary receptacle- and/or packaging items include various containers and container systems, such as vials, bottles, flasks, ampules, sample tubes, cuvettes, syringes, cartridges, injector pens, as well as bags (e.g. intravenous solution bags) and blister packs.

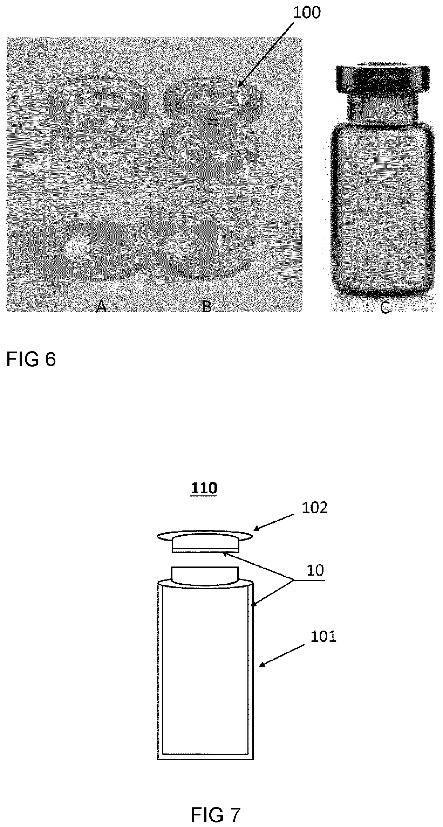

In some embodiments, the receptacle- and/or packaging item is configured as a medical package. In some embodiments, the medical package is a primary package having its interior wall or a layer brought into direct contact with the contents of the package. Exemplary receptacle- and/or packaging item 100 provided as a coated glass vial is shown on Fig. 6, B.

The coating film 10 can be applied onto all or selected surfaces of the receptacle- and/or packaging item. Preferred approach include providing the coating film only on those surfaces of the receptacle- and/or packaging item that come into direct contact with its contents. For receptacle and/or packaging items configured to contain and/or store the product inside, the coated surface is typically an inner surface. Coated surfaces further include closure- or capping elements for various container systems, such as stoppers, caps and seals.

In some instances, such as for example if isolation/masking of some parts of the substrate is difficult/inefficient, the coating film 10 may be applied onto all surfaces of the receptacle- and/or packaging item. Surface or surfaces of the receptacle- and/or packaging item deposited or intended for deposition with the coating film 10 are further collectively referred to as a substrate, and designated on Figs. 1A-1C with reference numeral 20.

The coating film 10 described herewith is designed to prevent substances migrating out of the substrate 20 material (such as a container or packaging material) from reaching the contents of the substrate (a product) susceptible to harmful interactions with these substances. It is preferred that the coating film 10 acts as a barrier that prevents essentially all unwanted substances from penetrating into the contents of the substrate.

The coating film 10 comprises one or more coating layers, hereafter, layers. In some configurations the coating film is configured as a uniform structure formed with a single material (see Fig. 1A). Said uniform structure may be formed with one or more coating layers. In some other configurations, the coating layer is configured as a laminate structure comprising a number of layers formed with different materials and arranged atop one another to form a stack. These laminate structures are referred to as "nanolaminates" as having thickness far below micrometer range. Overall, the coating film 10 (implemented as any one of a single-material or laminate solution) has a thickness of at least 1 nm, typically, within a range of about 5 nm to about 300 nm.

On Fig. 1B, nanolaminate stack is formed with two materials, wherein a first deposition layer 10-1 is formed with a first material M1 having a first composition, and a second deposition layer 10-2 (formed on the layer M1) is formed with a second material M2 having a second composition non-identical to the first composition. First deposition layer M1 can be formed directly on the substrate, as shown on Fig. 1B, or, alternatively, a primer deposition layer may be provided between the substrate and the first deposition layer M1 to improve adhesion of the coating film to the substrate (not shown). Fig. 1C shows a multilayer configuration, comprising more than two deposition- or coating layers (10-1, 10-2 ... 10n-1 and 10n). These layers can be arranged into repetitive patterns to form a stack, with each said pattern comprising two (2) to four (4) deposition layers composed of non-identical chemical compounds.

Deposition layers are preferably formed on the substrate 20 via a process of ALD.

The basics of an ALD growth mechanism are known to a skilled person. ALD is a chemical gas phase thin film deposition method based on alternate supply of at least two reactive precursor species (in gaseous phase) to a substrate, which forces the film growth reactions to proceed only on the surface in a highly controlled manner. It is to be understood, however, that one of these reactive precursors can be substituted by energy when using, for example, plasma-enhanced ALD (PE-ALD), or photon-enhanced ALD, leading to single precursor ALD processes. Thin films grown by ALD are dense, pinhole free and have uniform thickness.

In ALD, the substrate is typically exposed to temporally separated precursor pulses in a reaction vessel to deposit material on substrate surface or surfaces by sequential self-saturating surface reactions. In the context of present disclosure, the term ALD comprises all applicable ALD-based techniques, as well as, equivalent or closely related technologies, including, but not limited to the following ALD sub-types: plasma-enhance ALD (PE-ALD) also referred to plasma-assisted ALD, and photon-enhanced ALD, also referred to as photo-ALD or flash enhanced ALD.

Deposition setup may be the one based on an ALD installation described in the U.S. patent no. 8211235 (Lindfors), for example, or on any installation, such as Picosun^{®} R-200, P-300 or P-1000 ALD system, available from Picosun Oy, Finland. Nevertheless, the features underlying a concept of the present invention can be incorporated into any other chemical deposition reactor generally embodied as a reactor for ALD, PE-ALD, and the like.

An exemplary ALD reactor comprises a reaction chamber that establishes reaction space (deposition space), in which production of coated items described herewith takes place. The reactor further comprises a number of appliances configured to mediate fluidic flow (inert fluids and reactive fluids containing precursor compounds P1, P2) into the reaction chamber. These appliances are provided as a number of intake lines / feedlines and associated switching and/or regulating devices, such as valves, for example. The reactor /reaction chamber is preferably configured to implement a top-to-bottom flow; however other solutions are not excluded.

Substrates to be coated are typically loaded on a substrate holder, which, in turn, is inserted inside the reaction chamber. In order to coat a batch of glass vials in the ALD reactor of the type indicated herein above, the vials may be provided on a substrate holder comprising, as an example, a number of protrusions configured to hold a vial in an upside down position. Such an arrangement advantageously allows for coating the outer surface(s) of the vials. In order to deposit the coating on an inner surface and/or on an entire surface of the vial, precursor gas may be supplied through the substrate holder to reach the interior of all vials positioned thereon (not shown). Alternatively, the substrate holder may be provided in the form of a shelf or basket preferably made of net- or grid material, such as steel grid, for example, in order to enable an unobstructed flow of process gasses therethrough. The substrate holder may be configured to incorporate several shelves or baskets arranged into a vertical rack. Substrate holders of any other configuration may be utilized, depending on substrates to be coated and/or on implementation of a reactor apparatus in which the coating process is conducted (e.g. batch reactor with vertical or horizontal loading, reactor configured for continuous coating, etc.), which configurations may include, but are not limited to horizontal platforms, sample trays, racks of various design, and the like.

A basic ALD deposition cycle consists of four sequential steps: (1) pulse A, (2) purge A, (3) pulse B, and (4) purge B. Reactive fluid entering the reaction chamber during pulses A and B is preferably a gaseous substance comprising a predetermined precursor chemical carried by an inert carrier (gas). Delivery of the precursor chemicals into the reaction space and film growth on the substrate is/are regulated by means of the abovesaid regulating appliances, such as e.g. three-way ALD valves, mass-flow controllers or any other device suitable for this purpose.

Overall, each deposition cycle (Pulse A - Purge A - Pulse B - Purge B) results in formation of 0.05-0.2 nm thick "sub-layer". This sequence is repeated until the desired material thickness is achieved. By way of example, a 20 nm coating film may thus be deposited in 100 or 200 deposition cycles with exemplary growth rate 0.2 nm or 0.1 nm per deposition cycle, respectively.

As indicated above, the coating film 10 may consist of one or more ALD-coating layers 10-1, 10-2, 10n-1, 10n, composed of same or different materials. In some instances, the coating film consists of a single material and hence may be viewed as a film consisting of a single coating layer (see Fig. 1A). In some other instances, as shown on Fig. 1B, the coating film is provided as a laminate structure, comprises at least two coating layers deposited with different materials. For example, a first coating layer composed of a first material M1 and having a first thickness may be produced in a predetermined number of deposition cycles. Thereafter, a second coating layer composed of a second material M2 and having a second thickness may be produced atop the first coating layer in similar manner (see Fig. 1B).

A plurality of ALD-deposition cycles results in the formation of a thin film ("coated film") from a timed deposition sequence, which is controlled by a logic unit or a microprocessor of the related deposition equipment setup. More simple or more complex deposition cycles / deposition sequences can be implemented. For example, deposition cycles can include three or more reactant vapor pulses separated by purging steps, or, alternatively, certain purge steps can be omitted. On the other hand, for example photon-enhanced ALD has a variety of options, such as using only one active precursor in a corresponding precursor set, with various options for purging.

Overall, deposition of 5-300 nm coating films proceeded at deposition temperatures within a range of about 80 °C to about 200 °C or about 250 °C. For some coatings, such as for example SiO₂, deposition temperatures up to 300 °C were advantageous. Deposition within a range of about 50 to about 125 °C enables or facilitates formation of coatings on heat-sensitive substrates, such as those containing heat-degradable biological substances, polymers and/or electric circuits.

The coating film 10 is preferably configured unreactive towards the contents of the substrate (i.e. towards a product provided in the receptacle and/or packaging item) and preferably - towards the substances released from the substrate. In this regard, the coating film 10 is advantageously configured inert at both sides; however, in some instances inertness towards the substances leached/extracted from container material may require different characteristics than inertness towards the product. This duality in function may be easily achieved by providing coating films 10 comprising a layer or layers made of a first material unreactive towards the contents of the substrate, and comprising a layer or layer made of a second material unreactive towards the substrate material. Some coating materials, such as for example silicon dioxide, provide necessary inertness at both sides, however, even in such cases, the coating film 10 may include deposition layer(s) having different composition and function, e.g. alumina acting as a primer layer to improve adhesion of further deposition layers on the substrate.

Simplified schematics of a barrier function of the coating film 10 is shown on Fig. 2B. Fig. 2B illustrates a situation, where a substrate 20 configured as a receptacle- and/or packaging item, in particular, a primary package for a pharmaceutical preparation (designated as "API" present in a suitable excipient) is coated with the coating film 10. The coating film 10 is deposited on substrate surface(s) being in direct contact with the product contained therein, i.e. on an inner surface of the receptacle/container. In comparison to conventional (uncoated) solutions shown on Fig. 2A, the substrate coated with the coating film 10 is prevented from releasing harmful substances into the product.

In experimental trials underlying the present disclosure, barrier function of the coating film 10 was assessed by evaluating hydrolytic resistance of the coated samples, measuring extract conductivity (using water conductivity shift measurement method), measuring the amount of leached elements, and taking scanning electron micrographs.

Coating films 10 were ALD-deposited in line with the following procedure. Substrates for deposition included borosilicate glass vials (Schott Fiolax), Type I Plus glass vials (Adelphi Healthcare Packaging, UK), and 1 mm borosilicate glass plates (Finnish Special Glass (Finland). Deposition trials were conducted batchwise, wherein each batch included about fifty (50) samples (vials or plates), in the Applied Materials^{®} Picosun^{™} P-300B^{™} deposition tool (Finland). Four (4) dummy vials containing silicon coupons were used for thickness monitoring.

After the samples were loaded into the reaction chamber, wherein a vacuum environment was created using a vacuum pump, and the temperature was adjusted to 125 °C (except for SiO₂ coating which was deposited at 125 °C and 300 °C). Standard ALD precursors (Pulse A) were delivered into the reaction chamber in a flow of inert gas (herein, nitrogen) sequentially with water or ozone (Pulse B). For examples, alumina (Al₂O₃) coating films were deposited with trimethylaluminium (TMA) and water, and titania (TiO₂) films were deposited with titanium tetrachloride (TiCl₄) and water. The chamber was purged with nitrogen gas between pulses. The sequence was repeated until the coating film 10 of desired thickness was deposited.

Some coating films 10 were produced with a single compound, and some other - with a combination of compounds (as nanolaminates). Single-material films included films composed of any one of aluminium(III) oxide (Al₂O₃), titanium(IV) oxide (TiO₂), hafnium(IV) oxide (HfO₂), zirconium(IV) oxide (ZrO₂), zinc oxide (ZnO), tantalum(V) oxide (Ta₂O₅), and silicon dioxide (SiO₂). Nanolaminate films were deposited as stacks comprising the following dyads: Al₂O₃-TiO₂, Al₂O₃-HfO₂, Al₂O₃-ZrO₂, and Al₂O₃-SiO₂. Each coating film 10 contained a 5 nm Al₂O₃ primer layer (adhesion-improving layer) deposited on the substrate to initiate the coating. The rest of the deposited layers were deposited atop this primer layer. Final coating films 10 had the following structure: 10 x (5 nm Al₂O₃ + 5 nm TiO₂/HfO₂/ZrO₂/SiO₂).

Deposition uniformity was ensured by measuring film thicknesses from silicon coupons using a spectroscopic ellipsometer. All coatings films had intended thicknesses of about 100 nm, with very little variation, which is indicative of repeatability of the ALD process relative to coating of 3D objects (glass vials).

Hydrolytic resistance tests were conducted in order to assess the ability of coated samples to withstand degradation or leaching when exposed to essentially aqueous environments over time.

Hydrolytic resistance tests were conducted on coated samples (herein, glass vials) according to the international standard ISO 4802-1 (Glassware - Hydrolytic resistance of the interior surfaces of glass containers). The standard method determines hydrolytic resistance of interior surfaces of glass containers when subjected to attack by water at 121 °C ± 1 °C for 60 min ± 1 min. The resistance is measured by titration of a known aliquot portion of the extraction solution produced with hydrochloric acid (HCl), solution, in which case the resistance is inversely proportional to the volume of acid required. The method was conducted with twelve (12) glass vials coated with films 10, and two titrations with 0.01M HCl were performed for the extracts of 50 ml. Minimum titrant dose was 0.02 ml.

Results have demonstrated that the uncoated borosilicate glass vial consumed 0.52 mL titrant whereas ALD-coated vials consumed 0.04-0.08 mL titrant (not shown).

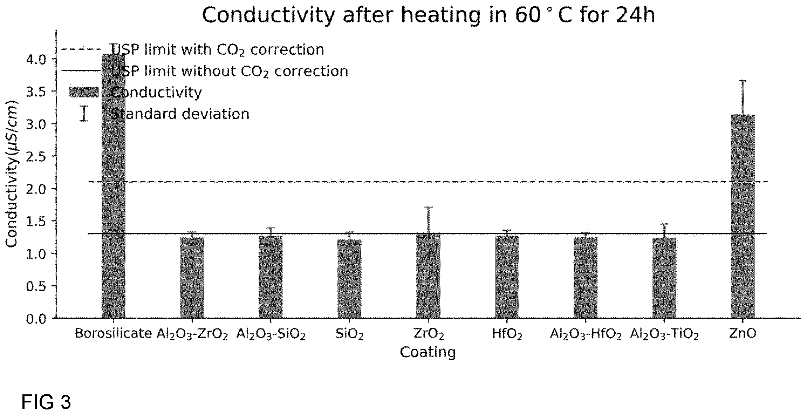

An in-house measurement method was developed to complement the extractables data. The method relied on the shift in water conductivity caused by the increase of ion concentration in de-ionized water (DIwater) after a predetermined time period at elevated temperature. Degradation of glass and the coating films (where applicable) cause an increase in ion concentration in the extract, thus leading to increased water conductivity. In the method, coated vials and their closure elements (stoppers) were rinsed with DI-water, the vials were filled with DIwater until the neck of the vial and stoppered, and further heated at 60 °C for 24 hours. Finally, the samples were cooled down to room temperature and the water conductivity was measured. Measurements were performed in triplicate using a Mettler Toledo SevenDirect conductivity meter with InLab 741-ISM measurement probe (Switzerland). Tests were performed under normal atmospheric conditions with carbon dioxide present in the air, which caused water conductivity to rise to about 1 microsiemens per centimeter (µS/cm). Therefore, CO₂ contribution was subtracted from test results. Results of conductivity measurements for different coating films 10 are shown on Fig. 3. Except for ZnO, all tested coatings have demonstrated conductivity values well below the limits set by the United States Pharmacopeia (USP, chapter 645, Water Conductivity) for water for injection (Fig. 3, USP limit with CO₂ correction). All coatings shown on Fig. 3 were deposited at 125 °C, except for SiO₂ which was deposited at 300 °C.

The water conductivity shift measurements well corresponded with the results obtained according to the ISO 4802-1 standard test. After contribution from carbon dioxide was subtracted from the results (Fig. 3, dotted line), no clear signs of coating dissolution was observed, except for the ZnO coating. For all other tested coating films, the difference between coated and uncoated vials is evident. Hence, it is clear that the coating films 10 prevent substate degradation and protect the contents of said substrates from substances originating from said degradation.

Hydrolytic resistance results were used to select coatings for extractables and leachables studies.

Extractables were quantified using Inductively Coupled Plasma Optical Emission Spectroscopy (ICP-OES). This technique measures the emission of light from elements excited in a plasma, allowing for the quantification of elemental concentrations in a sample. Prior to ICP-OES, samples were pre-treated using the standard method of ISO 4802-1 described above, thereafter conditions for accelerating leaching and delamination were created according to the method of USP 1660 (Evaluation of the inner surface durability of glass containers). All samples were analyzed in triplicate and the quantified elements were Si, Na, B, Ca, Al, Zr and Ti. Na and Si could not be quantified in citrate buffer due to spectral interference with the specific matrices.

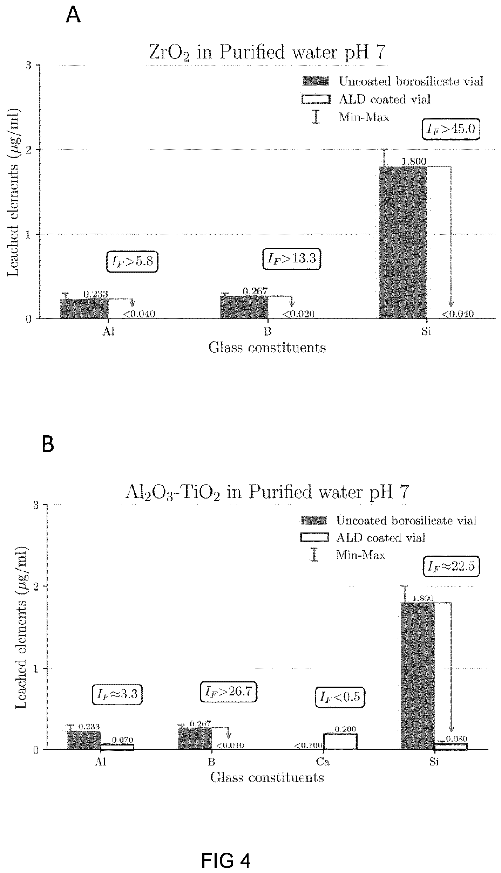

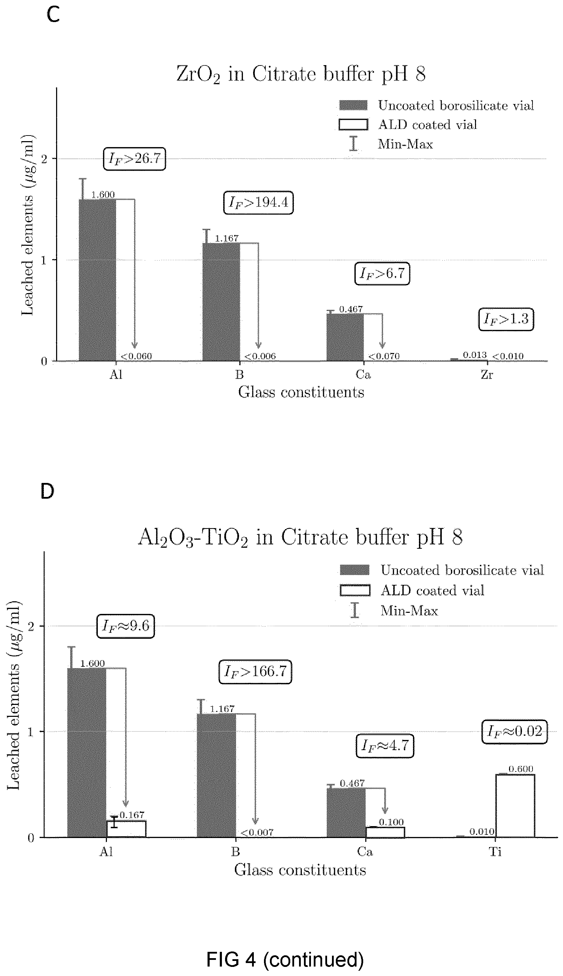

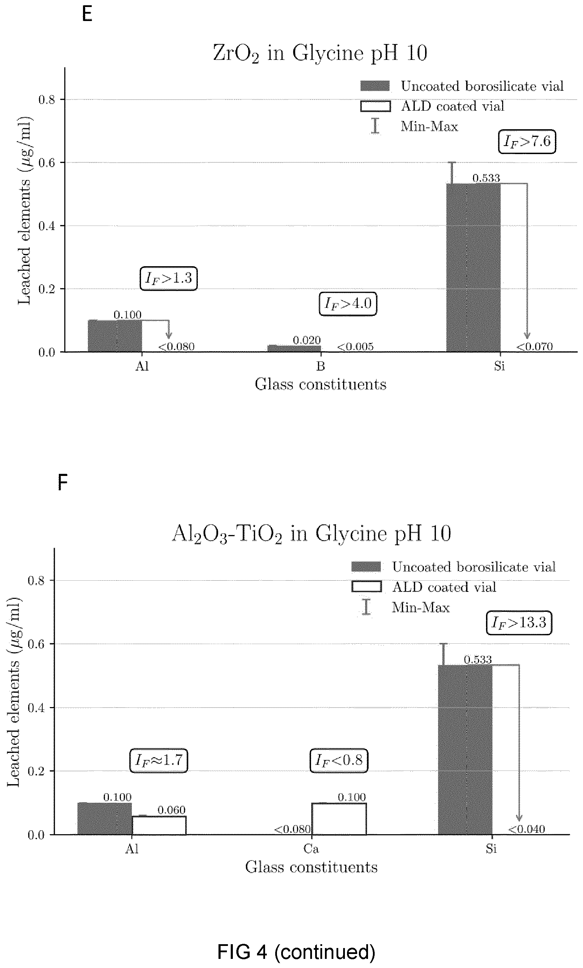

The results of ICP-OES studies for selected coatings (ZrO₂ and Al₂O₃-TiO₂) are shown on Fig. 4 (A-F). Concentration of leached elements (µg/ml) in purified water, pH 7; in sodium citrate buffer, pH 8 (hereafter, citrate buffer); and in glycine solution, pH 10 are shown on graphs A-B, C-D and E-F, respectively. Numerical values above the bars show either the average measured quantity or the limit of quantification (LOQ) when the results were below it. Improvement factor (IF) was defined as the amount of leached elements from uncoated sample divided by the amount from a coated one.

These results demonstrate that for (borosilicate) glass vials coated with the coating film 10 composed of ZrO₂, all analyzed extractables were below the limit of quantification (LOQ), being indicative of a superior chemical durability. Thus, in purified water, the improvement factors ranged from > 5.8 up to >45.0 for the glass constituents (Fig. 2, graph A). In citrate buffer, the improvement factors were between >6.7 and >194.4 (Fig. 2, graph C), and in glycine buffer - between >1.3 and >7.6 (Fig. 2, graph E). Equal results were obtained for a 10 x (5 nm Al₂O₃ + 5 nm ZrO₂) coating film (data not shown). This indicates that even a minimal thickness (herein, 5 nm) of ZrO₂ provides an excellent chemical durability, as alumina tends to dissolve in at least the citrate buffer.

Results for the Al₂O₃-TiO₂ nanolaminate in purified water were similar: detected amount of Si was decreased by 22.5-fold and practically no Al, B and Ti were detected from the coated vials (Fig. 2, graph B; results for Ti were negligible, therefore, not shown). In citrate buffer, minor amounts of Al (0.17 µg/ml) and Ca (0.10 µg/ml) were observed, and 0.60 µg/ml of Ti was detected (Fig. 2, graph D). Elevated concentration of Ti in citrate buffer indicated minor dissolution of the coating. However, since the Al concentration remained low, it seems that only the outermost layer(s) of the coating film consisting, hereby, of TiO₂ had deteriorated. In glycine, the nanolaminate coating remained stable, as essentially all the elements were below the limits of quantification (Fig. 2, graph F). A single result from triplicates gave a measurable concentration for the Al, being probably a data outlier.

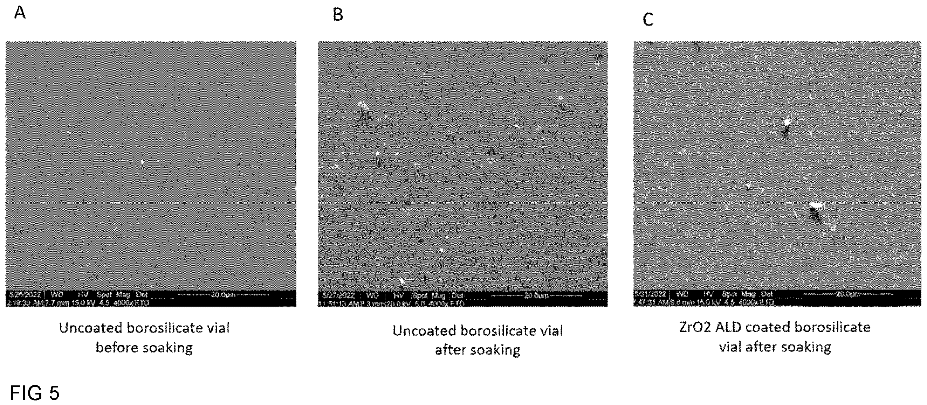

The state of the glass surface was further assessed with scanning electron microscopy (SEM) using Field Emission Microscope Quanta from Thermo Fischer Scientific, USA. SEM images were taken from the vial neck, wall and heel regions. However, since the heel region is typically most prone to degradation due to inhomogeneities in glass matrix occurring during formation of the vial, Fig. 5 shows SEM images obtained from the vial heel region.

Images were taken from an uncoated borosilicate vial as received (A); after exposing the uncoated borosilicate vial to accelerated soaking test conditions (B), and after exposing the borosilicate vial coated with 100 nm ZrO₂ coating film to accelerated soaking test conditions (C). Accelerated soaking test conditions included soaking the vial in 3% citrate buffer adjusted to pH 8, for 24 h at 80 °C. Particles seen in the images can be attributed to external sources (e.g. dust), since they were present in constant quantities across all the samples, while no delamination was observed. From Fig. 5 it may be observed that the surface of the uncoated vial prior to the accelerated conditions is smooth, with no surface pitting (Fig. 5, A). After exposing the uncoated vial to accelerated soaking test conditions, surface pitting could be observed (Fig. 5, B). However, as viewed from Fig. 5, C, the surface of borosilicate vial coated with the coating film 10 (herein, 100 nm ZrO₂ film) resembles the surface of the intact coated glass vial (Fig. 5, A), demonstrating a smooth surface. The lack of surface pitting in the ZrO₂-coated vial indicates that the coating can withstand harsh test conditions, and correlates well with the results of the extractable studies (Fig. 4, A, C, E). Thus, there is an evident correlation between the surface pitting and the extractable concentrations.

In embodiments, the coating film 10 is configured to provide see-through visibility with a human eye, when deposited on essentially transparent, see-through surfaces. Hence, the coating film 10 deposited on essentially transparent, see-through glass (clear or colored, such as borosilicate glass, for example), does not hinder transparency of the (uncoated) glass substrate and/or visibility therethrough with the human eye.

Fig. 6 shows different glass vials, where (A) is a clear (fully transparent) uncoated glass vial; (B) is the glass vial (same as in A) coated with the coating film 10 (coating thickness 100 nm); and (C) is a vial made of amber glass. When deposited on a surface of a clear (fully transparent) glass vial, the coating film 10 is almost fully invisible except demonstrating, in some instances, a minor sheen at the vial surface, which could be also completely eliminated by modifying the coating thickness. However, the glass vial coated with the coating film 10 (Fig. 6, B) is clearly far more transparent than, for example, the amber vial (Fig. 6, C), making the visual inspection easier.

The present invention further pertains to a method of depositing a coating film 10 on a substrate preferably configured as a receptacle- and/or packaging item 100 that contains a product susceptible to interaction with a material forming an interior of the item 100 upon being brought into direct contact therewith, and hence - a method of manufacturing a coated item 100, wherein the coating film 10 provides a barrier to substances migrating out of the material forming the interior of the receptacle- and/or packaging item, thereby preventing said substances from contaminating the product contained therein. The method comprises at least the following steps:
(i) obtaining a receptacle- and/or packaging item 100; and
(ii) on a surface or surfaces configured to come into direct contact with the contents of the receptacle- and/or packaging item, depositing a coating film 10 by a process of Atomic Layer Deposition (ALD).

The method comprises depositing of the coating film 10 according to the previously described embodiments.

The coating method is applicable for deposition the coating film 10 on a surface or surfaces of any receptacle- and/or packaging item made of glass and/or polymer, including, but not limited any one of: vials, bottles, flasks, ampules, bags, sample tubes, syringes, cartridges, injector pens, as well as microfluidic devices, well devices, such as well plates utilized in a variety of *in vitro* cell experiments, for example, as well as closures and other parts related to the above mentioned items. Overall, the receptacle and/or packaging item can be any container suitable for enclosing a product / a substance susceptible to potentially harmful interactions with the material releasing from the container's interior upon being brought into direct contact with the contents of the container.

The present invention further pertains to receptacle- and/or packaging item 100, comprising the coating film 10 according to the embodiments. The item 100 is preferably made of glass and/or polymer, preferably, elastomer, and configured to enclose and store substances in liquid form, in gel-like form or in solid form, including preparations pressed into shape, particulates and powders.

In embodiments, the receptacle- and/or packaging item 100 is configured as a medical package to enclose and store pharmaceutical preparations and medicine preparations. It is preferred that the receptacle- and/or packaging item 100 is configured as a primary package for pharmaceutical preparations. Overall, the item 100 may be configured as any one of a vials, bottles, flasks, ampules, bags, sample tubes, syringes, cartridges, injector pens, as well as microfluidic devices, well devices, such as well plates utilized in a variety of *in vitro* cell experiments, for example, as well as closures and other parts related to the above mentioned items. Exemplary item 100 in the form of a glass vial is shown on Fig. 6, B.

It is preferred that the coated surface(s) of said item is/are configured to come into direct contact with a substance / a product contained therein.

The receptacle and/or packaging item 100 may be viewed as a container system comprising a container body and a closure element for said container body. Exemplary configuration of such container system is shown, at 110, on Fig. 7. The container system 110 comprises a container body 101 and a closure element 102, wherein the surfaces of 101, 102 configured to come into direct contact with the contents of the container system 110 are coated with the coating film 10, according to the embodiment described hereinabove. Fig. 7 visualizes the container system 110 in the form of a sealable vial, wherein the container body 101 is a vial and its closure element 102 is a seal or a stopper. Hence, the surfaces that come into direct contact with a product are the interior wall of the vial and an inner surface of the closure element.

In some embodiments, it is preferred that the container body is made of glass, and the closure element is made of polymer, preferably elastomer. Provision of the container system 110, wherein both container body 101 and the closure element 102 are made of e.g. glass or polymer, is not excluded. For example, the entire container system may be made of suitable polymer materials.

The invention should not be understood as limited to configuration of Fig. 7. The container system 110 may thus be provided as any closable container such as for example a bottle, flask, tube or ampule with a related closure element.

In some instances, any one of the container body and the closure element, or both, can be coated with the coating film 10.

In embodiments, any one of the receptacle and/or packaging item 100 and/or the container system 110 are particularly suitable for enclosing and/or storing a pharmaceutical preparation in short-term or long-term.

It shall be appreciated by those skilled in the art that with the advancement of technology the basic ideas of the present invention may be implemented and combined in various ways. The invention and its embodiments are thus not limited to the examples described hereinabove, instead they may generally vary within the scope of the claims.

### REFERENCES

1. Xia Z, Rozyyev V, Mane AU, Elam JW, Darling SB. Surface Zeta Potential of ALD-Grown Metal-Oxide Films. Langmuir 2021 37 (39), 11618-11624. DOI: 10.1021/acs.langmuir.1c02028.

## Claims

1. A coating film deposited by a process of Atomic Layer Deposition (ALD) on at least one surface of a substrate configured to contain a product susceptible to interaction with a substrate material upon being brought into direct contact therewith, the coating film providing a barrier to substances migrating out of the substrate material into the product, thereby preventing said substances from contaminating the product contained in the substrate.

2. The coating film of claim 1, comprising one or more layers composed of any one of aluminium(III) oxide (Al₂O₃), titanium(IV) oxide (TiO₂), hafnium(IV) oxide (HfO₂), zirconium(IV) oxide (ZrO₂), zinc oxide (ZnO), tantalum(V) oxide (Ta₂O₅), silicon dioxide (SiO₂), and combinations thereof.

3. The coating film of claim 1 configured as a laminate structure, in which the layers are arranged into repetitive patterns, wherein each said pattern comprises two (2) to four (4) layers composed of non-identical chemical compounds.

4. The coating film of any preceding claim, configured as a barrier against extractables and/or leachables releasing from the substrate material upon interaction between the product and the substrate material.

5. The coating film of any preceding claim, wherein composition and/or thickness of said coating film is/are determined based on a material of the substrate to be coated and/or based on a composition of the product to be contained in the substrate.

6. The coating film of any preceding claim, deposited on the substrate configured as glass and/or polymer, preferably, elastomer.

7. A method of depositing a coating film on a receptacle- and/or packaging item configured to contain a product susceptible to interaction with a material forming an interior of said receptacle- and/or packaging item upon being brought into direct contact therewith, the method comprising:
(i) obtaining a receptacle- and/or packaging item; and
(ii) on a surface or surfaces configured to come into direct contact with the product within the receptacle- and/or packaging item, depositing a coating film by a process of Atomic Layer Deposition (ALD),
wherein the coating film provides a barrier to substances migrating out of the material forming the interior of the receptacle- and/or packaging item, thereby preventing said substances from contaminating the product contained therein, and
wherein the receptacle- and/or packaging item is configured as any one of: a container, a vial, a bottle, a flask, an ampule, a bag, a sample tube, a syringe, a cartridge, an injector pen, and the like.

8. The method of claim 7, comprising producing the coating film by depositing, via ALD, one or more layers composed of any one of: aluminium(III) oxide (Al₂O₃), titanium(IV) oxide (TiO₂), hafnium(IV) oxide (HfO₂), zirconium(IV) oxide (ZrO₂), zinc oxide (ZnO), tantalum(V) oxide (Ta₂O₅), silicon dioxide (SiO₂), and combinations thereof.

9. The method of any one of claims 7 or 8, comprising producing the coating film configured as a laminate structure, in which the layers are arranged into repetitive patterns, wherein each said pattern comprises two (2) to four (4) layers composed of non-identical chemical compounds.

10. The method of any one of claims 7-9, wherein the receptacle- and/or packaging item or parts thereof is/are made of glass and/or polymer, preferably, elastomer.

11. The method of any one of claims 7-10, wherein the receptacle- and/or packaging item is configured as a primary package for products.

12. The method of claim 7, wherein composition and/or thickness of the coating film deposited at step (*ii*) is/are determined based on a material of the receptacle- and/or packaging item to be coated and/or based on a composition of the product to be contained in said receptacle- and/or packaging item.

13. A receptacle- and/or packaging item configured to contain a product, the item, having at least one of its surfaces coated with a coating film as defined in any one of claims 1-6 and/or deposited with a method defined in any one of claims 7-12, wherein the coated surface(s) of said item is/are configured to come into direct contact with the product contained therein.

14. The receptacle- and/or packaging item of claim 13, made of glass and/or polymer, preferably, elastomer.

15. The receptacle- and/or packaging item of any one of claims 13 or 14 configured to contain a product provided in a liquid form, a gel-like form or a solid form.

16. The receptacle- and/or packaging item of any preceding claim 13-15, configured as a vial, a bottle, a flask, an ampule, a bag, a sample tube, a syringe, a cartridge, an injector pen, and the like.

17. A container system for storing a product, the container system comprising a container body and a closure element for said container body, wherein a surface or surfaces of any one of the container body and the closure element, or both, configured to come into direct contact with the contents of the container system is/are coated with a coating film as defined in any one of claims 1-6 and/or deposited with a method defined in any one of claims 7-12.

18. The container system of claim 17, wherein the container body is made of glass and the closure element is made of polymer, preferably elastomer.

19. The container system of any one of claims 17 or 18, wherein the container body is configured as a vial and the closure element is configured as a stopper or a seal.

20. Use of a receptacle and/or packaging item as defined in any one of claims 13-16 and/or of the container system as defined in any one of claims 17-19 for storing products.

21. The use of claim 20, wherein the product is any one of a chemical formulation, a biological formulation, or a pharmaceutical preparation.
